(19) Europäisches Patentamt / European Patent Office / Office européen des brevets

(11) **EP 4 379 396 B1**

(12) **EUROPEAN PATENT SPECIFICATION**

(45) Date of publication and mention
of the grant of the patent:
**06.05.2026 Bulletin 2026/19**

(21) Application number: **22275152.1**

(22) Date of filing: **01.12.2022**

(51) International Patent Classification (IPC):
**G01P 15/125** (2006.01) **G01P 15/08** (2006.01)
**B81B 3/00** (2006.01)

(52) Cooperative Patent Classification (CPC):
**G01P 15/125; B81B 3/007;** B81B 2201/0235;
B81B 2203/0136; G01P 2015/0814;
G01P 2015/0857

(54) **DESIGN OPTIMISATION OF ACCELEROMETER SUPPORTS**

ENTWURFSOPTIMIERUNG VON BESCHLEUNIGUNGSMESSERTRÄGERN

OPTIMISATION DE LA CONCEPTION DE SUPPORTS D'ACCÉLÉROMÈTRE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**05.06.2024 Bulletin 2024/23**

(73) Proprietor: **Atlantic Inertial Systems Limited
Plymouth, Devon PL6 6DE (GB)**

(72) Inventors:
• **FELL, Christopher Paul
Plymouth Devon PL6 6DE (GB)**
• **BAXTER, Jason
Plymouth Devon PL6 6DE (GB)**

• **TOWNSEND, Kevin
Plymouth Devon PL6 6DE (GB)**
• **MILWARD, Thomas Oliver
Plymouth Devon PL6 6DE (GB)**

(74) Representative: **Dehns
10 Old Bailey
London EC4M 7NG (GB)**

(56) References cited:
**US-A1- 2017 010 300    US-B1- 6 230 566**

• **MAJID TAGHAVI ET AL: "A Closed-Loop MOEMS
Accelerometer", ARXIV.ORG, CORNELL
UNIVERSITY LIBRARY, 201 OLIN LIBRARY
CORNELL UNIVERSITY ITHACA, NY 14853, 7
February 2022 (2022-02-07), XP091158138**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present disclosure relates to a sensing structure for a capacitive accelerometer with high sensitivity.

Background

Accelerometers are electromechanical devices that are widely used to measure acceleration forces due to motion and/or vibration. Capacitive accelerometers are typically implemented as micro-electromechanical systems (MEMS) and may be manufactured from a semiconductor material such as silicon. A typical MEMS for a capacitive accelerometer includes a sensing structure, comprising a resonator structure in the form of a proof mass moveably mounted to one or more flexible spring supports, with a set of moveable electrode fingers extending from the proof mass. The electrode fingers of the sensing structure are interdigitated with one or more sets of fixed capacitive electrode fingers so as to form a differential capacitor. The sensing structure is connected, via a plurality of electrodes, to suitable drive and pickoff electronics to drive and sense the in-plane motion of the proof mass relative to the fixed capacitive electrode fingers.

Such accelerometers may be operated in an "open loop" configuration, in which the electronics are arranged to drive the fixed capacitive electrode fingers with a suitable waveform, such as a sine or square wave signal, such that when the proof mass moves under an applied acceleration a pickoff voltage signal appears on the output. Alternatively, accelerometers may be operated in a "closed loop" configuration, in which the proof mass is maintained in a fixed position at all times by applying electrostatic forces to the fixed capacitive electrode fingers to achieve force balancing. The force required to maintain the proof mass in the fixed position while under acceleration can then be used to determine the acceleration applied to the accelerometer.

In order to provide an accelerometer with high sensitivity, it is desirable for the flexible supports of the resonator structure to have low stiffness, which allows for greater displacement of the proof mass in response to an applied acceleration. In closed loop operation, high voltages are required to control the motion of the proof mass during high-g operation. However, these voltages can cause the proof mass to come into contact with the fixed capacitive electrode fingers as a result of the electrostatic attraction between the two components overcoming the mechanical restoring force of the flexible supports. If this occurs, the proof mass collides with the fixed electrodes, and will remain fixed at the electrode surface. To prevent this, the minimum stiffness of the flexible supports is typically limited, effectively limiting the maximum sensitivity of the accelerometer that may be achieved.

The magnitude of the mechanical restoring force is sensitive to variations in the stiffness of the flexible supports and the magnitude of the electrostatic attraction is sensitive to the width of the gaps between the fixed and movable capacitive electrodes. Both of these parameters may change due to variations in the fabrication process. This results in significant variations in the total stiffness even for devices where the mechanical restoring force is greater than the electrostatic attraction. This introduces a variation in the accelerometer performance that is undesirable and which also contributes to yield loss during device manufacture.

It is an object of the present disclosure to address one or more of the disadvantages outlined above, in order to provide a capacitive accelerometer with high sensitivity.

Majid Taghavi et al: "A Closed-Loop MOEMS Accelerometer", Arxiv.Org, Cornell University Library, 201 Olin Library Cornell University Ithaca, NY 14853, 7 February 2022, XP091158138 discloses a closed-loop micro-opto-electro-mechanical system (MOEMS) accelerometer based on the Fabry-Perot (FP) interferometer.

US 2017/010300 A1 discloses a physical quantity sensor including a movable electrode side fixed section, a first fixed electrode side fixed section which has a first fixed electrode section and a second fixed electrode side fixed section which has a second fixed electrode section, a movable mass section which has a first movable electrode section that has a portion facing the first fixed electrode section and a second movable electrode section that has a portion facing the second fixed electrode section and which is formed in a shape that encloses the movable electrode side fixed section, the first fixed electrode side fixed section, and the second fixed electrode side fixed section in planar view, and an elastic section which connects the movable electrode side fixed section and the movable mass section.

Summary

From a first aspect of the disclosure, there is provided a sensing structure for a capacitive accelerometer according to claim 1.

As will be described further below, by employing one or more flexible supports having a width along the sensing axis that is substantially equal to the size of a gap defined between the fixed capacitive electrode(s) and the proof mass along the sensing axis, the sensitivity and signal to noise characteristics of an accelerometer in which the sensing structure is employed are improved. This is achieved by allowing lower stiffness supports to be used, which allows for greater proof mass displacement in response to applied acceleration, while ensuring that the proof mass and the first and second fixed capacitive electrodes do not collide.

In at least some examples, the sensing structure may comprise an external frame surrounding the resonator structure and the fixed electrodes, and a third gap may be defined along the sensing axis between the one or more flexible supports and the external frame. The third gap may have the same size as the gap defined between at least one of the first and second fixed capacitive electrodes and the proof mass under zero applied acceleration. As the sensing structure may be formed by etching, e.g. using Deep Reactive Ion Etching (DRIE), selecting the third gap to have the same size as the as the gap defined between at least one of the first and second fixed capacitive electrodes and the proof mass under zero applied acceleration ensures that etch widths are optimally matched. This can advantageously ensure that differences in etch tolerance error are minimised. Etch tolerance error can be made more consistent across the sensing structure.

In at least some examples, the proof mass may comprise a plurality of moveable capacitive electrode fingers extending perpendicular to the sensing axis and spaced apart in the direction of the sensing axis. The first and/or second fixed capacitive electrode may comprise a plurality of fixed capacitive electrode fingers extending perpendicular to the sensing axis and spaced apart in the direction of the sensing axis.

In at least some examples, the fixed capacitive electrode fingers of the first and/or second electrode may be arranged to interdigitate with the moveable electrode fingers of the proof mass. In at least some examples, the first and second fixed capacitive electrodes are mounted, directly or indirectly, to a substrate. The flexible supports of the resonator structure may be arranged to mount the proof mass to the same substrate (e.g. by anchors as described below).

In at least some such examples, the first set of fixed capacitive electrode fingers may be arranged to interdigitate with the moveable capacitive electrode fingers of the proof mass with a first offset in one direction from a median line therebetween, and the second set of fixed capacitive electrode fingers may be arranged to interdigitate with the moveable capacitive electrode fingers of the proof mass with a second offset in the opposite direction from a median line therebetween.

In at least some examples, the resonator structure may form an outer frame surrounding the first and second fixed capacitive electrodes. In at least some examples in which the proof mass comprises a plurality of moveable electrode fingers, said moveable electrode fingers may extend inwardly from the outer frame and perpendicular to the sensing axis.

In at least some examples, the outer frame may comprise first and second rigid sections, connected by a rigid beam extending between the first and second rigid sections perpendicular to the sensing axis. The first fixed electrode and the second fixed electrode may thus be arranged such that the first fixed electrode is positioned above the rigid beam along the sensing axis while the second fixed electrode is positioned below the rigid beam along the sensing axis.

In at least some examples, the one or more flexible supports may extend perpendicular to the sensing axis inwardly from the proof mass to a central anchor on the fixed support, the fixed anchor having a position along the sensing axis that is centred with respect to the proof mass.

In at least some examples, the resonator structure may comprise a pair of flexible supports located at opposite sides of the proof mass. In such examples, each flexible support may be arranged to mount the resonator structure to the substrate, e.g. via an anchor for mounting to the substrate. The anchor may be arranged such that it has a position along the sensing axis that is centred with respect to the proof mass.

In at least some examples, the one or more flexible supports may extend linearly between the proof mass and the anchor. In at least some examples, the one or more flexible supports may extend with a serpentine form between the proof mass and the anchor. In at least some examples, the one or more flexible supports may be folded beams. In various examples, the one or more flexible supports may have a substantially constant width along the sensing axis. In at least some examples, the proof mass may be substantially planar, and the first and second fixed capacitive electrodes may be in the same plane as the proof mass.

In at least some examples, each of the proof mass, fixed support frame, flexible supports and first and second fixed capacitive electrodes may be formed from a common material layer. The material layer may comprise a semiconductor material, e.g. silicon. The substrate may also be formed of the same semiconductor material, e.g. silicon.

In at least some examples, the first and second fixed capacitive electrodes may be arranged symmetrically with respect to the proof mass. In at least some examples in which the first and/or second fixed capacitive electrode comprises a plurality of fixed capacitive electrode fingers, the first and/or second set of fixed capacitive electrode fingers may be arranged symmetrically along the sensing axis and/or perpendicular to the sensing axis.

In at least some examples, the sensing structure may be a microelectromechanical structure (MEMS). The MEMS may be formed from a semiconductor material, e.g. silicon.

The present disclosure extends to a capacitive accelerometer comprising a sensing structure as described above.

Brief description of the drawings

Non-limiting examples of the present disclosure will now be described with reference to the accompanying figures, in which:

Figure 1 is a schematic representation of a MEMS sensing structure for a capacitive accelerometer according to the present disclosure;

Figure 2 is schematic representation of a section of the MEMS sensing structure for a capacitive accelerometer according to the present disclosure;

Figures 3a and 3b are plots showing the variation in mechanical spring stiffness $k_x$ in the sensing direction (x-axis), electrical spring stiffness $k_e$, and total spring stiffness $k_t$ with etch tolerance error $\Delta$ for an accelerometer according to a conventional design, and designed in accordance with the present disclosure respectively;

Figure 4 is a plot showing the variation in total spring stiffness $k_t$ with etch tolerance error $\Delta$ for an accelerometer according to a conventional design, and designed in accordance with the present disclosure;

Figure 5 is a plot showing the variation in total spring stiffness $k_t$ with etch tolerance error $\Delta$ for accelerometers having a flexible supports with a range of widths; and

Figure 6 is a plot showing the variation in total spring stiffness $k_t$ with etch tolerance error $\Delta$ for an accelerometer according to a modified conventional design.

Detailed description

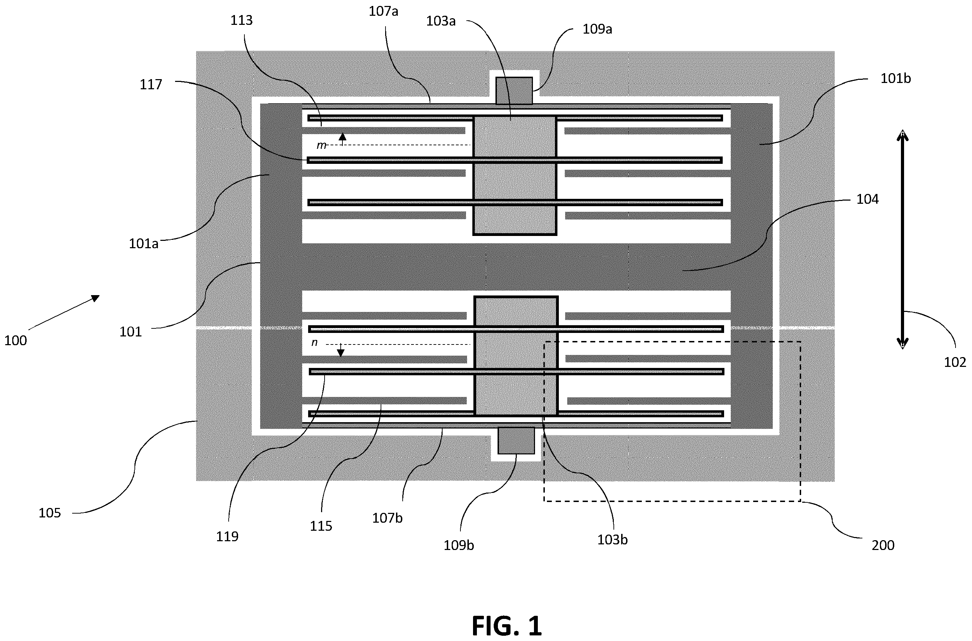

Figure 1 is a schematic representation of a sensing structure 100 for use in a MEMS capacitive accelerometer, formed from a semiconductor material layer. The MEMS sensing structure 100 comprises a resonator structure including a proof mass 101, and first and second fixed electrodes 103a, 103b, which are rigidly attached to an underlying substrate (not shown). The proof mass 101 comprises two rigid sections 101a, 101b which are elongated in the sensing direction 102, and are connected via a rigid beam 104b.

The proof mass 101 is substantially planar and is mounted, via flexible supports 107a, 107b, to fixed anchor points 109a, 109b to form a resonator structure. The fixed anchor points 109a, 109b, are rigidly fixed to the substrate, such that the proof mass 101 is linearly moveable in a plane along the sensing axis 102 (indicated by the double-headed arrow 102 in Figure 1) in response to an applied acceleration.

The proof mass 101, flexible supports 107a, 107b, and anchor points 109a, 109b of the resonator structure are surrounded by an external frame 105, which is also attached to the substrate (not shown in Figure 1). In the example shown in Figure 1, the flexible supports 107a, 107b are support beams that have a uniform width along the sensing axis 102, and which extend in a straight line between a respective anchor point 109a, 109b, and each of the two rigid sections 101a, 101b of the proof mass 101. However, those skilled in the art will appreciate that these supports could also be in the form of uniform serpentine or folded beams.

The proof mass 101 comprises first and second sets of moveable capacitive electrode fingers 113, 115 extending from the proof mass 101, substantially perpendicular to the sensing axis 102 and spaced apart along the sensing axis.

The first and second fixed capacitive electrodes 103a, 103b are formed in the same plane as the external frame 105, and comprise respective sets of fixed capacitive electrode fingers 117, 119 extending substantially perpendicular to the sensing axis from the central anchor points 109a, 109b which are rigidly attached to the substrate (not shown) and spaced apart along the sensing axis 102.

The first set of fixed capacitive electrode fingers 117 is arranged to interdigitate with the first set of moveable capacitive electrode fingers 113 with a first offset in one direction along the sensing axis 102 from a median line m between adjacent fixed capacitive electrode fingers 117, and the second set of fixed capacitive electrode fingers 119 is arranged to interdigitate with the second set of moveable capacitive electrode fingers 115 with a second offset in the opposite direction along the sensing axis 102 from a median line n between adjacent fixed capacitive electrode fingers 119.

The respective offsets between the fixed capacitive electrode fingers 117, 119 and the moveable capacitive electrode fingers 113, 115 result in a small capacitor gap (i.e. the distance between adjacent pairs of fixed and moveable capacitive electrode fingers) on one side of the moveable electrode fingers 113, 115, and a larger capacitor gap on the other. The overall capacitance between the fixed capacitive electrode fingers 117, 119 and the moveable capacitive electrode fingers 113, 115 is therefore dominated by the capacitance derived from the small capacitor gap. The ratio of the large capacitor gap to the small capacitor gap is preferably ≥ 2.5:1. This ensures that the detected signals and applied drive forces (for closed loop operation) are dominated by the small capacitor gaps.

Although the first and second fixed electrodes 103a, 103b are each shown as having six capacitive electrode fingers 117, 119 in the schematic representation shown in Figure 1, it will be appreciated that significantly greater numbers of fixed and moveable capacitive electrode fingers are present in the sensing structure 100 in practice, but are not shown in Figure 1 for simplicity of illustration.

The proof mass 101 can move in-plane relative to the fixed electrodes 103a, 103b in a direction along the sensing axis 102 in response to an applied acceleration. As the two sets of fixed capacitive electrode fingers 117, 119 are offset from the moveable capacitive electrode fingers 113, 115 extending from the proof mass 101 in opposite directions, movement in either direction can be measured. The difference in offset for the first set of fixed capacitive electrode fingers 117 and the second set of fixed capacitive electrode fingers 119 relative to the moveable capacitive electrode fingers 113 and 115 respectively, causes an attractive force between pairs of fixed and moveable electrode fingers when a drive signal (e.g. a voltage waveform) is applied to the first and second sets of fixed capacitive electrode fingers 117, 119.

In open loop operation, movement of the proof mass 101 in response to an applied acceleration causes a change in the offset between the proof mass fingers 113, 115 and the fixed capacitive electrode fingers 117, 119. One of the capacitor gaps will increase with the other decreasing, depending on the direction of the applied acceleration. This differential change in offset can be used to calculate the acceleration of the proof mass 101, as it will cause a change in differential capacitance. In closed loop operation, the interdigitated electrode fingers do not actually move relative to one another. Instead, differential adjustment of the pulse width modulation (PWM) of first and second drive signals applied to the first and second fixed capacitive electrode fingers 117, 119 is used to generate an electrostatic force that acts on the moveable capacitive electrode fingers 113, 115 of the proof mass 101, so that under acceleration the proof mass 101 does not move from the null position shown in Figure 1 (i.e. the position of the proof mass under zero applied acceleration), with the inertial force of the applied acceleration being balanced by a net electrostatic force. In this "force feedback" mode, the electrostatic force required to balance inertial force can be used to determine the applied acceleration.

As described above, the proof mass 101 is connected to the fixed anchor points 109a, 109b (and hence the substrate), by flexible supports 107a, 107b. As can be seen in Figure 1, the flexible support 107b is narrow relative to the proof mass 101. The flexible supports 107a, 107b can thus bend in response to motion of the proof mass 101 under an applied acceleration, but also provide a mechanical restoring force to limit the distortion and to bring the proof mass 101 back to its zero-acceleration position. The displacement of the proof mass 101 is thus dependent on the stiffness of the flexible supports 107a, 107b, such that low-stiffness supports allow greater motion of the proof mass 101 in response to an applied acceleration. The stiffness of the supports 107a, 107b thus sets the sensitivity of an accelerometer in which the sensing structure 100 is used.

In order to provide high sensitivity, supports 107a, 107b of low stiffness are required to allow for greater displacement of the proof mass in response to an applied acceleration.

The overall stiffness of the resonator structure formed from the proof mass 101 and the flexible supports 107a, 107b is dependent on both the mechanical stiffness $k_x$, of the flexible supports 107a, 107b (which depends on the in-plane width and length of the flexible supports 107a, 107b), and the electrical stiffness, $k_e$, of the resonator structure, which results from the differential voltage between the capacitive electrode fingers 113, 115 of the proof mass 101 and the capacitive electrode fingers 117, 119 of the fixed electrodes 103a, 103b. The mechanical stiffness $k_x$ of the flexible supports 107a, 107b also depends on the thickness of the flexible supports 107a, 107b in the out of plane direction, which may be set by etching depth. There is also a contribution to the electrical stiffness $k_e$ from the capacitor formed between the flexible supports 107a, 107b and the adjacent fixed electrode 103a, 103b. In practical devices this contribution to $k_e$ is significantly smaller than that from the multiplicity of proof mass electrode fingers 113, 115, which provide a significantly larger capacitive area.

Unlike the mechanical stiffness $k_x$, which acts as a "positive" spring to return the proof mass 101 to the null position when an acceleration is applied, the capacitance and voltage between the capacitive electrode fingers 113, 115 of the proof mass 101, and the fixed electrodes 103a, 103b has the effect of a "negative" spring, which acts to pull the proof mass 101 towards the fixed electrodes 103a, 103b. The resultant overall stiffness, $k_t$, of the resonator structure (i.e. the proof mass 101 and the flexible supports 107a, 107b) is thus the sum of these two effects.

The combined mechanical stiffness of the flexible supports 107a, 107b may be given by:

$$k_x = 4E\frac{d_{thick}d_{width}^3}{d_{length}^3}$$

where E is the Youngs modulus of the flexible support, $d_{thick}$ is the thickness of the flexible support in the out of plane direction, $d_{width}$ is the width of the flexible support along the sensing axis 102, and $d_{length}$ is the length of the flexible support in the same plane as the sensing axis, but perpendicular to the sensing axis.

The electrical spring softening of the resonator structure, which consists of the proof mass 101, the flexible supports 107a, 107b and the moveable electrode fingers 113, 115 of the proof mass 101 may be given by:

$$k_e = 2e_0e_rV^2d_{thick}d_{cap}\left(\frac{1}{d_{small}^3} + \frac{1}{d_{big}^3}\right)$$

Where $e_0$ is the permittivity of free space, $e_r$ is the permittivity of the gas between the capacitor plates, V is the voltage difference between the fixed capacitive electrode fingers 117, 119 of the fixed electrodes 103a, 103b, and the moveable electrode fingers 113, 115 of the proof mass 101, $d_{thick}$ is the thickness of the material layer in which the electrode fingers are formed (i.e. in the out of plane direction), $d_{cap}$ is the length of the fixed and moveable electrode fingers acting as a pair of capacitor plates, $d_{small}$ is the size of the smaller gap between the finger pairs, and $d_{big}$ is the size of the larger gap between finger pairs.

The total stiffness of the resonator structure can then be given as the difference between the mechanical stiffness $k_x$ and the electrical stiffness $k_e$, i.e. as

$$k_t = k_x - k_e$$

In order for the accelerometer to function, the total stiffness $k_t$ must be positive, as a negative overall stiffness would result in a net attractive force between the proof mass 101 and the electrodes 103a, 103b, causing the proof mass 101 to collide with the electrodes 103a, 103b, preventing the accelerometer from functioning. Thus, there is a requirement that mechanical stiffness $k_x$ must be higher than the electrical stiffness $k_e$ under all operating conditions. However, the smaller the total stiffness $k_t$, the greater the sensitivity of the accelerometer in which the MEMS sensing structure 100 is applied, as greater displacement of the proof mass 101 is achieved in response to a given applied acceleration.

The mechanical stiffness $k_x$ is proportional to $d_{width}^3$ and $1/d_{length}^3$ and is therefore highly sensitive to changes in these parameter values which may occur due to fabrication process variations. The electrical stiffness $k_e$ is sensitive to changes in both $d_{small}$ and $d_{big}$ however, as $d_{big}$ is typically > x2.5 larger than $d_{small}$ this term is dominant and therefore $k_e$ is approximately proportional to $1/d_{small}^3$. The electrical stiffness $k_e$ is therefore highly sensitive to fabrication process variations which change $d_{small}$. Accurate control of these fabrication process induced dimensional changes is therefore essential to achieve a high sensitivity accelerometer.

**When forming** a MEMS sensing structure 100 as shown in Figure 1, etching processes such as Deep Reactive Ion Etching (DRIE) are typically used. During such etching processes, the dimensions of each part of the MEMS sensing structure 100 may vary slightly due to inherent tolerance errors in the etching process.

The amount by which this width varies is the etching tolerance error $\Delta$, which arises due to differences in the degree of lateral (sideways) etching as vertical trenches are formed in a semiconductor substrate. The amount of lateral etching that occurs for an intended etch width is typically predictable to within the etching tolerance error $\Delta$. For example, for a 10 micron etch mask, side etching typically results in a 12 micron wide trench, with an etch tolerance error $\Delta$ around this expected width of 12 microns. A typical value of the etch tolerance error $\Delta$ may be in the range ±0.5 μm. Gaps between components (e.g. the spacing between the fixed and moveable electrode fingers, $d_{small}$, $d_{big}$) increase as $\Delta$ increases. However, the thickness of components (e.g. the width of the flexible supports 107a, 107b in the in-plane direction, $d_{width}$), which are determined by the trench widths on either side, decrease as $\Delta$ increases. This is the result of the trench widths on either side of the component increasing, leading to a net reduction in the thickness of the component.

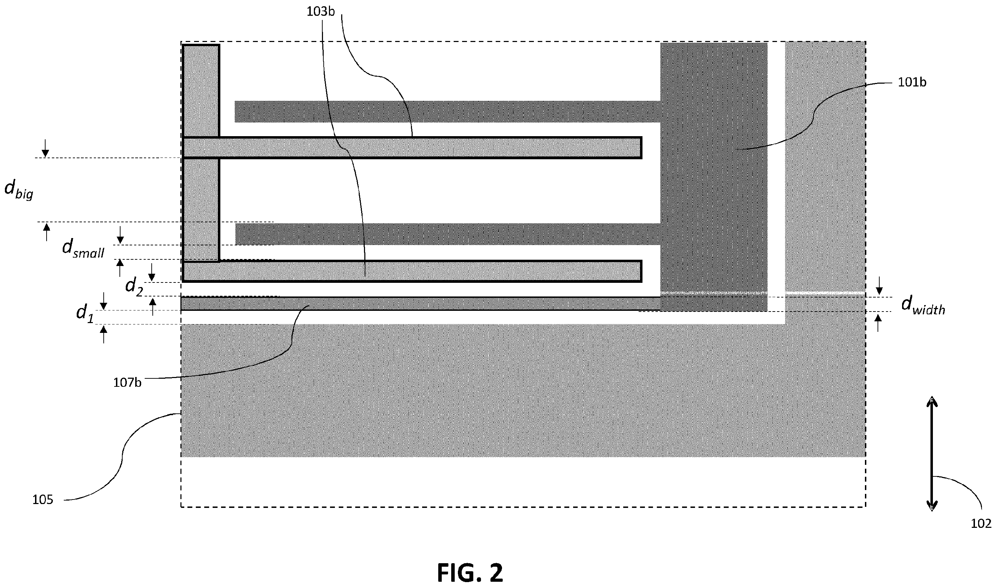

For example, the flexible support 107b shown in Figure 2 is formed by etching a first trench between the flexible support 107b and the external frame 105, and a second trench between the fixed electrode finger 119 and the flexible support 107b. This is shown in more detail in Figure 2, which illustrates a region 200 of the MEMS sensing structure shown in Figure 1 close to the point of connection between the flexible support 107b and the rigid section 101b of the proof mass 101.

Figure 2 shows a first trench between the flexible support 107b and the external frame 105 with a width $d_1$, and a second trench between the electrode finger 119 and the flexible support 107b of width $d_2$. If the etch tolerance error on either side increases, the widths $d_1$ and $d_2$ increase, leading to a reduction in the width of the flexible support $d_{width}$. The etch tolerance $\Delta$ is typically very consistent across the area of a single MEMS chip however there may be a small difference in this value depending on the width of the DRIE trench with wider trenches tending to exhibit slightly larger errors. It is therefore beneficial to set the values of $d_1$ and $d_2$ to be both equal to the small gap size, $d_{small}$. This ensures optimal matching of these DRIE trench widths.

As the etching tolerance error is highly variable, the dimensions of the flexible supports 107a, 107b are typically selected to be large relative to the gaps between the fixed and moveable capacitive electrode fingers in order to ensure that the overall stiffness $k_t$ is always positive. This ensures that a functioning accelerometer may be made even if the etching tolerance error $\Delta$ is large. Designs with high mechanical stiffness $k_x$ relative to the electrical stiffness $k_e$ are thus required, resulting in a significant loss of sensitivity, i.e. the minimum achievable stiffness is limited when etch tolerance error becomes an important factor, e.g. for designs in which the spacing between capacitive electrodes is of the order of the etch tolerance error $\Delta$. As the etch tolerance error $\Delta$ is typically in the range ±0.5μm, accelerometers having spacing between fixed and moveable capacitive electrode fingers on the micrometre scale may be significantly affected.

The present inventors have recognised however, that the overall stiffness may be significantly reduced, and kept relatively constant (despite etch tolerance errors) by appropriately selecting the values of $d_{small}$ and $d_{width}$. In particular, by setting the width $d_{width}$ of the flexible supports 107a, 107b equal to the size of the smaller gap between the capacitor finger pairs, $d_{small}$, a low stiffness flexible support may be provided while remaining substantially immune to etch tolerance variations, as when these values are used, $k_x$ and $k_e$ are found to vary almost identically (in percentage terms) in response to changes in etch tolerance error $\Delta$.

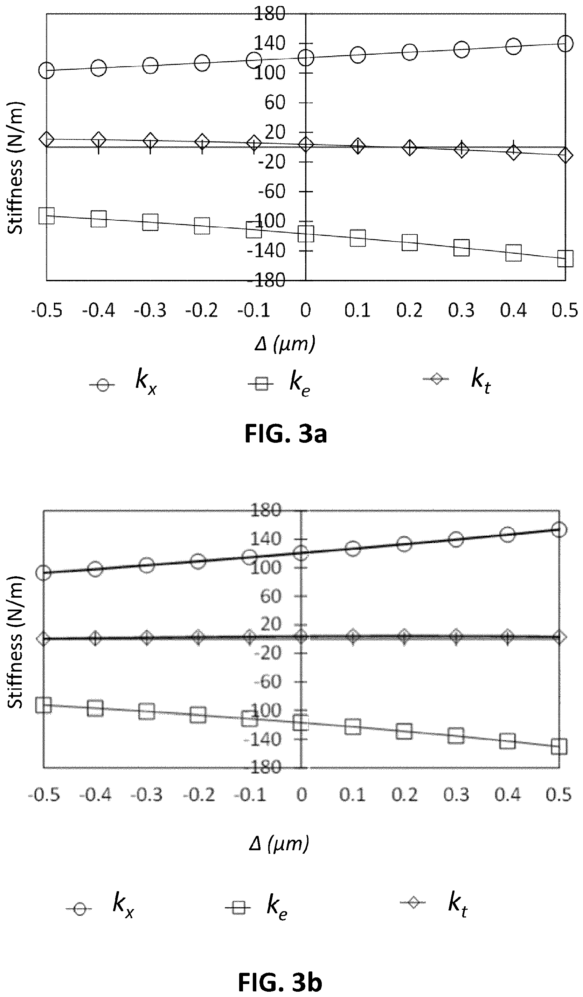

This is illustrated in Figures 3a and 3b, which show the variation in mechanical spring stiffness $k_x$, electrical spring stiffness $k_e$, and total spring stiffness $k_t$ with etch tolerance error $\Delta$ for an accelerometer designed in accordance with conventional approaches, i.e. having $d_{width} > d_{small}$ (Figure 3a), as well as for an accelerometer according to the present disclosure, in which $d_{width} = d_{small}$ (Figure 3b).

Specifically, in the conventional accelerometer example shown in Figure 3a, $d_{width}$ = 10 $\mu m$ while $d_{small}$ = 6 $\mu m$, while in the example shown in Figure 3b, $d_{width}$ = $d_{small}$ = 6 $\mu m$. For each plot, the electrical stiffness values $k_e$ are identical (i.e. the two accelerometer designs have the same spacing between the fixed and moveable capacitive electrode fingers as well as the same area), and the mechanical stiffness values $k_x$ have been adjusted to be equal at zero tolerance error by varying the length of the flexible supports to achieve equal spring stiffness for both designs. Thus, all variation in spring stiffness with etch tolerance error is attributable to differences in $d_{width}$ and $d_{small}$ between the two.

It can be seen in Figure 3a that for a conventional accelerometer design with $d_{width}$ > $d_{small}$, the resultant stiffness $k_t$ is highly variable with etch tolerance error $\varDelta$, and for certain values of etch tolerance error (e.g. $\varDelta$ > 0.3$\mu m$), the resultant stiffness, $k_t$ is negative.

In contrast, for an accelerometer according to the present disclosure with $d_{width}$ = $d_{small}$, as shown in Figure 3b, the resultant stiffness $k_t$ is considerably more stable, and remains positive across the entire range of etch tolerance error $\varDelta$ shown.

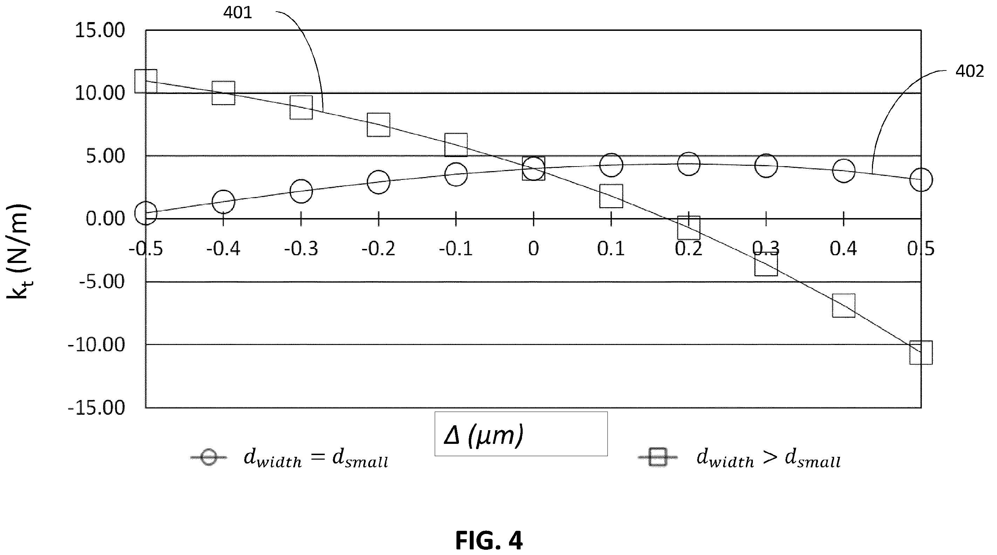

This difference in overall stiffness $k_t$ is shown in more detail in Figure 4, in which the difference in stability of overall stiffness $k_t$ over a range of etch tolerance errors $\varDelta$ between a conventional accelerometer (curve 401) and an accelerometer according to the present disclosure (curve 402) is evident. It can also be seen in Figure 4 that for an accelerometer according to the present disclosure, the resultant stiffness $k_t$ remains positive across the entire range of etch tolerance error.

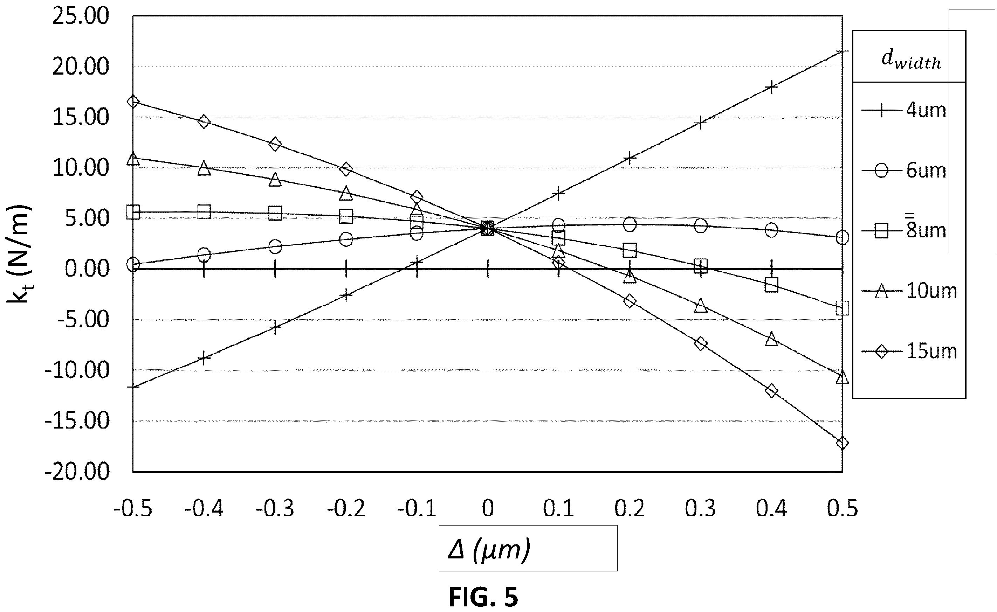

The variation in overall stiffness $k_t$ for different flexible support widths, $d_{width}$, for a constant spacing between the fixed and moveable electrode fingers, $d_{small}$, of 6 $\mu$m is illustrated in Figure 5. Figure 5 shows the variation in $k_t$ with etch tolerance error $\varDelta$ for a range of flexible support widths $d_{width}$ between 4 $\mu$m and 15 $\mu$m. In these design variants the length of the flexible supports 107a, 107b has been adjusted to achieve the same $k_x$, and hence the same $k_t$ value, at the nominal zero tolerance error. It can be seen that for these variants the resultant stiffness $k_t$ only remains positive across the entire range of etch tolerance error $\varDelta$ for a flexible support width of 6 $\mu$m, i.e. equal to the predetermined spacing between the fixed and moveable electrode fingers $d_{small}$.

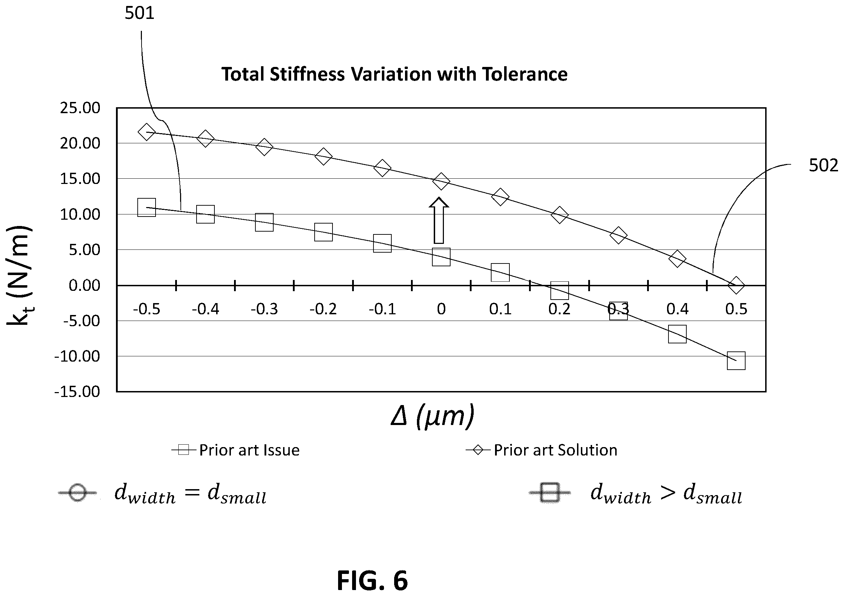

**In order for** the other width variants shown in Figure 5 to be usable, the stiffness at zero etch tolerance would need to be significantly increased to avoid negative values from occurring within the range of etch tolerance error $\varDelta$. This is shown in Figure 6 for the example where $d_{width}$ = 10 $\mu$m. The mechanical stiffness $k_x$ can be seen to be increased by reducing the length of the flexible supports 107a, 107b as shown in curve 502. This results in an accelerometer with a $k_t$ value at the nominal zero tolerance error that is over three times higher than in typical designs, as represented in curve 501. This would result in significantly increased stiffness, and hence degraded and variable accelerometer sensitivity across the tolerance range.

However, by providing an accelerometer in which the nominal width of the flexible supports 107a, 107b is equal to the minimum etch gap width between the fixed electrodes 117, 119 and the moveable electrodes 113, 115 of the proof mass 101, the mechanical stiffness $k_x$ and the electrical stiffness $k_e$ vary almost identically (in percentage terms), allowing the overall stiffness of the flexible supports 107a, 107b to be minimised while remaining substantially immune to tolerance variations. This allows the accelerometer of the present disclosure to have significantly improved sensitivity in comparison to the prior art.

It will be appreciated by those skilled in the art that the disclosure has been illustrated by describing one or more specific examples thereof, but is not limited to these aspects; many variations and modifications are possible, within the scope of the accompanying claims.

## Claims

1. A sensing structure (100) for a capacitive accelerometer, the sensing structure (100) comprising:

   a resonator structure (101, 107a, 107b) comprising a proof mass (101) and one or more flexible supports (107a, 107b) for mounting the resonator structure to a substrate, the proof mass (101) being moveable along a sensing axis (102) in response to an applied acceleration; and
   first and second fixed capacitive electrodes (103a, 103b) arranged either side of the proof mass (101) along the sensing axis (102);
   wherein a gap ($d_{small}$) is defined along the sensing axis (102) between each of the first and second fixed capacitive electrodes (103a, 103b) and the proof mass (101) under zero applied acceleration; and
   wherein the one or more flexible supports (107a, 107b) has a width ($d_{width}$) along the sensing axis (102) that is substantially equal to the size of the gap ($d_{small}$) defined between at least one of the first and second fixed capacitive electrodes (103a, 103b) and the proof mass (101) under zero applied acceleration; **characterised in that**:
   a second gap ($d_2$) is defined along the sensing axis (102) between at least one of the one or more flexible supports (107a, 107b) and at least one of the fixed capacitive electrodes (103a, 103b), said second gap ($d_2$) having the same size as the gap ($d_{small}$) defined between at least one of the first and second fixed capacitive electrodes (103a, 103b) and the proof mass (101) under zero applied acceleration.

2. The sensing structure (100) of claim 1, further comprising an external frame (105) surrounding the resonator structure (101, 107a, 107b) and the fixed electrodes (103a, 103b), wherein a third gap ($d_1$) is defined along the sensing axis (102) between the one or more flexible supports (107a, 107b) and the external frame (105), said third gap ($d_1$) having the same size as the gap ($d_{small}$) defined between at least one of the first and second fixed capacitive electrodes (103a, 103b) and the proof mass (101) under zero applied acceleration.

3. The sensing structure of claim 1 or 2, wherein the proof mass (101) comprises a plurality of moveable capacitive electrode fingers (113, 115) extending perpendicular to the sensing axis (102) and spaced apart in the direction of the sensing axis (102).

4. The sensing structure of claim 3, wherein the first and/or second fixed capacitive electrode (103a, 103b) comprises a plurality of fixed capacitive electrode fingers (117, 119) extending substantially perpendicular to the sensing axis (102) and spaced apart in the direction of the sensing axis (102).

5. The sensing structure (100) of claim 4, wherein the fixed capacitive electrode fingers (117, 119) are arranged to interdigitate with the moveable capacitive electrode fingers (113, 115) of the proof mass (101).

6. The sensing structure (100) of claim 5, wherein a first set of fixed capacitive electrode fingers (117) is arranged to interdigitate with the moveable electrode fingers (113, 115) of the proof mass (101) with a first offset in one direction from a median line therebetween, and a second set of fixed capacitive electrode fingers (119) is arranged to interdigitate with the moveable electrode fingers (113, 115) of the proof mass (101) with a second offset in the opposite direction from a median line therebetween.

7. The sensing structure (100) of any preceding claim, wherein the resonator structure (101, 107a, 107b) forms an outer frame surrounding the first and second fixed capacitive electrodes (103a, 103b).

8. The sensing structure (100) of claim 7, wherein the proof mass comprises a first rigid section (101a) and second rigid section (101b), connected by a rigid beam (104) extending between the first rigid section (101a) and the second rigid section (101b) perpendicular to the sensing axis (102).

9. The sensing structure of claim 8, wherein the first fixed electrode (103a) is positioned above the rigid beam (104) along the sensing axis (102) and the second fixed electrode (103b) is positioned below the rigid beam (104) along the sensing axis (102).

10. The sensing structure (100) of any preceding claim, wherein the resonator structure (101, 107a, 107b) comprises a pair of flexible supports (107a, 107b) located at opposite sides of the proof mass (101), each flexible support (107a, 107b) being arranged to mount the resonator structure to the substrate.

11. The sensing structure (100) of any preceding claim, wherein the one or more flexible supports (107a, 107b) extends perpendicular to the sensing axis (102) inwardly from the proof mass (101) to an anchor (109a, 109b) for mounting to the substrate, the anchor (109a, 109b) having a position along the sensing axis (102) that is centred with respect to the proof mass (101).

12. The sensing structure (100) of claim 11, wherein the one or more flexible supports (107a, 107b) extends linearly between the proof mass (101) and the anchor (109a, 109b), and/or wherein the one or more flexible supports (107a, 107b) has a substantially constant width along the sensing axis (102).

13. The sensing structure (100) of any preceding claim, wherein the proof mass (101) is substantially planar, and wherein the first and second fixed capacitive electrodes (103a, 103b) are in the same plane as the proof mass (101).

14. The sensing structure (100) of any preceding claim, wherein the proof mass (101), the flexible supports (107a, 107b) and first and second fixed capacitive electrodes (103a, 103b) are formed from a common material layer.

**Patentansprüche**

1. Erfassungskonstruktion (100) für einen kapazitiven Beschleunigungsmesser, wobei die Erfassungskonstruktion (100) umfasst:

eine Resonatorkonstruktion (101, 107a, 107b), die eine Prüfmasse (101) und einen oder mehrere flexible Träger (107a, 107b) zum Montieren der Resonatorkonstruktion an einem Substrat umfasst, wobei die Prüfmasse (101) als Reaktion auf eine ausgeübte Beschleunigung entlang einer Erfassungsachse (102) beweglich ist; und eine erste und eine zweite feste kapazitive Elektrode (103a, 103b), die auf beiden Seiten der Prüfmasse (101) entlang der Erfassungsachse (102) angeordnet sind; wobei unter null ausgeübter Beschleunigung ein Spalt ($d_{klein}$) entlang der Erfassungsachse (102) zwischen jeder der ersten und zweiten festen kapazitiven Elektroden (103a, 103b) und der Prüfmasse (101) definiert ist; und
wobei der eine oder die mehreren flexiblen Träger (107a, 107b) entlang der Erfassungsachse (102) eine Breite ($d_{breite}$) aufweisen, die im Wesentlichen gleich der Größe des Spalts ($d_{klein}$) ist, der unter null ausgeübter Beschleunigung zwischen mindestens einer der ersten und zweiten festen kapazitiven Elektroden (103a, 103b) und der Prüfmasse (101) definiert ist; **dadurch gekennzeichnet, dass**:
ein zweiter Spalt ($d_2$) entlang der Erfassungsachse (102) zwischen mindestens einem des einen oder der mehreren flexiblen Träger (107a, 107b) und mindestens einer der festen kapazitiven Elektroden (103a, 103b) definiert ist, wobei der zweite Spalt ($d_2$) die gleiche Größe aufweist wie der Spalt ($d_{breite}$), der unter null ausgeübter Beschleunigung zwischen mindestens einer der ersten und zweiten festen kapazitiven Elektroden (103a, 103b) und der Prüfmasse (101) definiert ist.

2. Erfassungskonstruktion (100) nach Anspruch 1, ferner umfassend einen äußeren Rahmen (105), der die Resonatorkonstruktion (101, 107a, 107b) und die festen Elektroden (103a, 103b) umgibt, wobei ein dritter Spalt ($d_1$) entlang der Erfassungsachse (102) zwischen dem einen oder den mehreren flexiblen Trägern (107a, 107b) und dem äußeren Rahmen (105) definiert ist, wobei der dritte Spalt ($d_1$) die gleiche Größe aufweist wie der Spalt ($d_{klein}$), der unter null ausgeübter Beschleunigung zwischen mindestens einer der ersten und zweiten festen kapazitiven Elektroden (103a, 103b) und der Prüfmasse (101) definiert ist.

3. Erfassungskonstruktion nach Anspruch 1 oder 2, wobei die Prüfmasse (101) eine Vielzahl von beweglichen kapazitiven Elektrodenfingern (113, 115) umfasst, die sich senkrecht zu der Erfassungsachse (102) erstrecken und in der Richtung der Erfassungsachse (102) voneinander beabstandet sind.

4. Erfassungskonstruktion nach Anspruch 3, wobei die erste und/oder zweite feste kapazitive Elektrode (103a, 103b) eine Vielzahl von festen kapazitiven Elektrodenfingern (117, 119) umfasst, die sich im Wesentlichen senkrecht zu der Erfassungsachse (102) erstrecken und in der Richtung der Erfassungsachse (102) voneinander beabstandet sind.

5. Erfassungskonstruktion (100) nach Anspruch 4, wobei die festen kapazitiven Elektrodenfinger (117, 119) derart angeordnet sind, dass sie mit den beweglichen kapazitiven Elektrodenfingern (113, 115) der Prüfmasse (101) ineinandergreifen.

6. Erfassungskonstruktion (100) nach Anspruch 5, wobei ein erster Satz von festen kapazitiven Elektrodenfingern (117) derart angeordnet ist, dass er mit den beweglichen Elektrodenfingern (113, 115) der Prüfmasse (101) mit einem ersten Versatz in einer Richtung von einer Mittellinie dazwischen ineinandergreift, und ein zweiter Satz von festen kapazitiven Elektrodenfingern (119) derart angeordnet ist, dass er mit den beweglichen Elektrodenfingern (113, 115) der Prüfmasse (101) mit einem zweiten Versatz in der entgegengesetzten Richtung von einer Mittellinie dazwischen ineinandergreift.

7. Erfassungskonstruktion (100) nach einem der vorhergehenden Ansprüche, wobei die Resonatorkonstruktion (101, 107a, 107b) einen äußeren Rahmen bildet, der die erste und die zweite feste kapazitive Elektrode (103a, 103b) umgibt.

8. Erfassungskonstruktion (100) nach Anspruch 7, wobei die Prüfmasse einen ersten starren Abschnitt (101a) und einen zweiten starren Abschnitt (101b) umfasst, die durch einen starren Balken (104) verbunden sind, der sich zwischen dem ersten starren Abschnitt (101a) und dem zweiten starren Abschnitt (101b) senkrecht zu der Erfassungsachse (102) erstreckt.

9. Erfassungskonstruktion nach Anspruch 8, wobei die erste feste Elektrode (103a) oberhalb des starren Balkens (104) entlang der Erfassungsachse (102) positioniert ist und die zweite feste Elektrode (103b) unterhalb des starren Balkens (104) entlang der Erfassungsachse (102) positioniert ist.

10. Erfassungskonstruktion (100) nach einem der vorhergehenden Ansprüche, wobei die Resonatorkonstruktion (101, 107a, 107b) ein Paar von flexiblen Trägern (107a, 107b) umfasst, die sich an gegenüberliegenden Seiten der Prüfmasse (101) befinden, wobei jeder flexible Träger (107a, 107b) dazu angeordnet ist, die Resonatorkonstruktion an dem Substrat zu montieren.

11. Erfassungskonstruktion (100) nach einem der vorhergehenden Ansprüche, wobei der eine oder die mehreren flexiblen Träger (107a, 107b) sich senkrecht zu der Erfassungsachse (102) von der Prüfmasse (101) nach innen zu einem Anker (109a, 109b) zur Montage an dem Substrat erstrecken, wobei der Anker (109a, 109b) eine Position entlang der Erfassungsachse (102) aufweist, die in Bezug auf die Prüfmasse (101) zentriert ist.

12. Erfassungskonstruktion (100) nach Anspruch 11, wobei sich der eine oder die mehreren flexiblen Träger (107a, 107b) linear zwischen der Prüfmasse (101) und dem Anker (109a, 109b) erstrecken, und/oder wobei der eine oder die mehreren flexiblen Träger (107a, 107b) entlang der Erfassungsachse (102) eine im Wesentlichen konstante Breite aufweisen.

13. Erfassungskonstruktion (100) nach einem der vorhergehenden Ansprüche, wobei die Prüfmasse (101) im Wesentlichen planar ist und wobei die erste und die zweite feste kapazitive Elektrode (103a, 103b) in derselben Ebene wie die Prüfmasse (101) liegen.

14. Erfassungskonstruktion (100) nach einem der vorhergehenden Ansprüche, wobei die Prüfmasse (101), die flexiblen Träger (107a, 107b) und die erste und die zweite feste kapazitive Elektrode (103a, 103b) aus einer gemeinsamen Materialschicht gebildet sind.

## Revendications

1. Structure de détection (100) pour un accéléromètre capacitif, la structure de détection (100) comprenant :

une structure de résonateur (101, 107a, 107b) comprenant une masse d'épreuve (101) et un ou plusieurs supports flexibles (107a, 107b) pour monter la structure de résonateur sur un substrat, la masse d'épreuve (101) étant mobile le long d'un axe de détection (102) en réponse à une accélération appliquée ; et

des première et seconde électrodes capacitives fixes (103a, 103b) agencées de chaque côté de la masse d'épreuve (101) le long de l'axe de détection (102) ;

dans laquelle un espace ($d_{small}$) est défini le long de l'axe de détection (102) entre chacune des première et seconde électrodes capacitives fixes (103a, 103b) et la masse d'épreuve (101) sous une accélération appliquée nulle ; et

dans lequel les un ou plusieurs supports flexibles (107a, 107b) ont une largeur ($d_{width}$) le long de l'axe de détection (102) sensiblement égale à la taille de l'espace ($d_{small}$) défini entre au moins l'une des première et seconde électrodes capacitives fixes (103a, 103b) et la masse d'épreuve (101) sous accélération appliquée nulle ; **caractérisée en ce que** :

un deuxième espace ($d_2$) est défini le long de l'axe de détection (102) entre au moins l'un des un ou plusieurs supports flexibles (107a, 107b) et au moins l'une des électrodes capacitives fixes (103a, 103b), ledit deuxième espace ($d_2$) ayant la même taille que l'espace ($d_{small}$) défini entre au moins l'une des première et seconde électrodes capacitives fixes (103a, 103b) et la masse d'épreuve (101) sous une accélération appliquée nulle.

2. Structure de détection (100) selon la revendication 1, comprenant en outre un cadre externe (105) entourant la structure de résonateur (101, 107a, 107b) et les électrodes fixes (103a, 103b), dans laquelle un troisième espace ($d_1$) est défini le long de l'axe de détection (102) entre les un ou plusieurs supports flexibles (107a, 107b) et le cadre externe (105), ledit troisième espace ($d_1$) ayant la même taille que l'espace ($d_{small}$) défini entre au moins l'une des première et seconde électrodes capacitives fixes (103a, 103b) et la masse d'épreuve (101) sous une accélération appliquée nulle.

3. Structure de détection selon la revendication 1 ou 2, dans laquelle la masse d'épreuve (101) comprend une pluralité de doigts d'électrodes capacitives mobiles (113, 115) s'étendant perpendiculairement à l'axe de détection (102) et espacés dans la direction de l'axe de détection (102).

4. Structure de détection selon la revendication 3, dans laquelle la première et/ou la seconde électrode capacitive fixe (103a, 103b) comprend une pluralité de doigts d'électrodes capacitives fixes (117, 119) s'étendant sensiblement perpendiculairement à l'axe de détection (102) et espacés dans la direction de l'axe de détection (102).

5. Structure de détection (100) selon la revendication 4, dans laquelle les doigts d'électrodes capacitives fixes (117, 119) sont agencés de manière à s'entremêler avec les doigts d'électrodes capacitives mobiles (113, 115) de la masse d'épreuve (101).

6. Structure de détection (100) selon la revendication 5, dans laquelle un premier ensemble de doigts d'électrodes capacitives fixes (117) est agencé de manière à s'entremêler avec les doigts d'électrodes mobiles (113, 115) de la masse d'épreuve (101) avec un premier décalage dans une direction par rapport à une ligne médiane entre eux, et un second ensemble de doigts d'électrodes capacitives fixes (119) est agencé de manière à s'entremêler avec les doigts d'électrodes mobiles (113, 115) de la masse d'épreuve (101) avec un second décalage dans la direction opposée par rapport à une ligne médiane entre eux.

7. Structure de détection (100) selon une quelconque revendication précédente, dans laquelle la structure de résonateur (101, 107a, 107b) forme un cadre extérieur entourant les première et seconde électrodes capacitives fixes (103a, 103b).

8. Structure de détection (100) selon la revendication 7, dans laquelle la masse d'épreuve comprend une première section rigide (101a) et une seconde section rigide (101b), reliées par une poutre rigide (104) s'étendant entre la première section rigide (101a) et la seconde section rigide (101b) perpendiculairement à l'axe de détection (102).

9. Structure de détection selon la revendication 8, dans laquelle la première électrode fixe (103a) est positionnée au-dessus de la poutre rigide (104) le long de l'axe de détection (102) et la seconde électrode fixe (103b) est positionnée au-dessous de la poutre rigide (104) le long de l'axe de détection (102).

10. Structure de détection (100) selon une quelconque revendication précédente, dans laquelle la structure de résonateur (101, 107a, 107b) comprend une paire de supports flexibles (107a, 107b) situés au niveau de côtés opposés de la masse d'épreuve (101), chaque support flexible (107a, 107b) étant agencé de manière à monter la structure de résonateur sur le substrat.

11. Structure de détection (100) selon une quelconque revendication précédente, dans laquelle les un ou plusieurs supports flexibles (107a, 107b) s'étendent perpendiculairement à l'axe de détection (102) vers l'intérieur depuis la masse d'épreuve (101) jusqu'à un ancrage (109a, 109b) pour le montage sur le substrat, l'ancrage (109a, 109b) ayant une position le long de l'axe de détection (102) qui est centrée par rapport à la masse d'épreuve (101).

12. Structure de détection (100) selon la revendication 11, dans laquelle les un ou plusieurs supports flexibles (107a, 107b) s'étendent linéairement entre la masse d'épreuve (101) et l'ancrage (109a, 109b), et/ou dans laquelle les un ou plusieurs supports flexibles (107a, 107b) ont une largeur sensiblement constante le long de l'axe de détection (102).

13. Structure de détection (100) selon une quelconque revendication précédente, dans laquelle la masse d'épreuve (101) est sensiblement plane, et dans laquelle les première et seconde électrodes capacitives fixes (103a, 103b) sont dans le même plan que la masse d'épreuve (101).

14. Structure de détection (100) selon une quelconque revendication précédente, dans laquelle la masse d'épreuve (101), les supports flexibles (107a, 107b) et les première et seconde électrodes capacitives fixes (103a, 103b) sont formés à partir d'une couche de matériau commune.

**FIG. 1**

**FIG. 2**

EP 4 379 396 B1

**FIG. 3a**

**FIG. 3b**

**FIG. 4**

EP 4 379 396 B1

**FIG. 5**

EP 4 379 396 B1

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 2017010300 A1

**Non-patent literature cited in the description**

• **MAJID TAGHAVI et al.** A Closed-Loop MOEMS Accelerometer. Cornell University Library, 07 February 2022